# EUROPÄISCHE PATENTSCHRIFT

(11) **EP 1 374 308 B1**
(45) Veröffentlichungstag und Bekanntmachung des Hinweises auf die Patenterteilung: **05.09.2012**
(21) Anmeldenummer: 02730029.2
(22) Anmeldetag: 19.03.2002
(51) Int. Cl.: H01L 27/12, H01L 21/84, H01L 27/115, H01L 21/8247

(54) **SPEICHERZELLENANORDNUNG MIT INDIVIDUEL ADRESSIERBAREN SPEICHERZELLEN UND VERFAHREN ZUR HERSTELLUNG DERSELBEN**
MEMORY CELL ARRAY WITH INDIVIDUALLY ADDRESSABLE MEMORY CELLS AND METHOD FOR THE PRODUCTION THEREOF
RESEAU DE CELLULES DE MEMOIRE COMPORTANT DES CELLULES DE MEMOIRE ADRESSABLES INDIVIDUELLEMENT ET SON PROCEDE DE FABRICATION

(30) Priorität: 05.04.2001 DE 10117037
(43) Veröffentlichungstag der Anmeldung: 02.01.2004
(73) Patentinhaber: Infineon Technologies AG, 85579 Neubiberg (DE)
(72) Erfinder: KAKOSCHKE, Roland, 81475 Muenchen (DE); WILLER, Josef, 85521 Riemerling (DE)
(74) Vertreter: Stöckeler, Ferdinand
(86) Internationale Anmeldenummer: PCT/EP2002/003041
(87) Internationale Veröffentlichungsnummer: WO 2002/082550

(56) Entgegenhaltungen:
- DE-A- 19 823 733
- US-A- 5 411 905
- US-A- 5 515 319
- US-A- 5 760 437
- PATENT ABSTRACTS OF JAPAN vol. 1997, no. 09, 30. September 1997 (1997-09-30) -& JP 09 116120 A (HITACHI LTD), 2. Mai 1997 (1997-05-02)
- PATENT ABSTRACTS OF JAPAN vol. 1997, no. 12, 25. Dezember 1997 (1997-12-25) -& JP 09 213910 A (SONY CORP), 15. August 1997 (1997-08-15)
- PATENT ABSTRACTS OF JAPAN vol. 1995, no. 07, 31. August 1995 (1995-08-31) -& JP 07 094686 A (NIPPON STEEL CORP), 7. April 1995 (1995-04-07)

## Beschreibung

Die vorliegende Erfindung bezieht sich auf ein Speicherzellenarray und ein Verfahren zur Herstellung desselben, und insbesondere ein solches Speicherzellenarray, dessen Speicherzellen einzeln adressierbar sind.

Nicht-flüchtige Speicher (NVM; NVM = Non Volatile Memories) finden heute breite Anwendung, wobei vor allem Floating-Gate-Speicherzellen zum Einsatz kommen. Man unterscheidet zwischen zwei Arten von Speichermodulen, zum einen Datenspeichern und zum anderen Programmspeichern.

Bei Datenspeichern müssen kleine Speichereinheiten, beispielsweise einzelne Bits, 1 Byte, das aus 8 Bit besteht, oder ein Wort, das aus 128 Bit besteht, wahlfrei löschbar und programmierbar sein, wobei es zu vielen Reprogrammierzyklen kommen kann.

Im Gegensatz dazu können bei Programmspeichern, die überwiegend als Flash-Speicher realisiert sind, nur große Einheiten, beispielsweise ein Sektor mit 512 kBit, pauschal gelöscht werden, bevor bitweise geschrieben bzw. programmiert wird. Soll beispielsweise nur 1 Byte neu geschrieben werden, so muß der gesamte Sektor gelöscht und neu geschrieben werden. Dies bedeutet eine unnötige Belastung der Zellen, die eigentlich nicht angesprochen werden sollen. Dadurch wird deren Lebensdauer erheblich herabgesetzt. Die Funktionalität eines Programmspeichers ist also eingeschränkt. Dafür ist bei einem Flash-Speicher eine höhere Speicherdichte realisierbar, da kleinere Zellflächen erforderlich sind.

Im Rahmen der folgenden Anmeldung soll unter Löschen einer Speicherzelle jeweils der Vorgang angesprochen werden, bei dem Ladungen in das Speichermedium, bei den angesprochenen Floating-Gate-Speicherzellen auf das Floating-Gate, einer Speicherzelle gebracht werden. Unter Schreiben bzw. Programmieren wird dann der Vorgang verstanden, bei dem entsprechende Ladungen von dem Speichermedium entfernt, d. h. abgezogen, werden.

Zur Realisierung von Datenspeichern, bei denen kleine Speichereinheiten wahlfrei löschbar und programmierbar sein müssen, ist es bekannt, solche Speichereinheiten in einer Wortleitung anzuordnen und durch sogenannte Byteschalter zu separieren. Derartige Byte-Schalter führen jedoch zu einer erheblichen Vergrößerung des Speichermoduls.

Alternativ zu den Byteschaltern ist es aus dem Stand der Technik bekannt, mit aufgeteilten Spannungen zu arbeiten, d. h. zum selektiven Programmieren bzw. Löschen einen Teil der Spannung über die Wortleitung und den anderen Teil über die Bitleitung einer Speicherzelle zuzuführen.

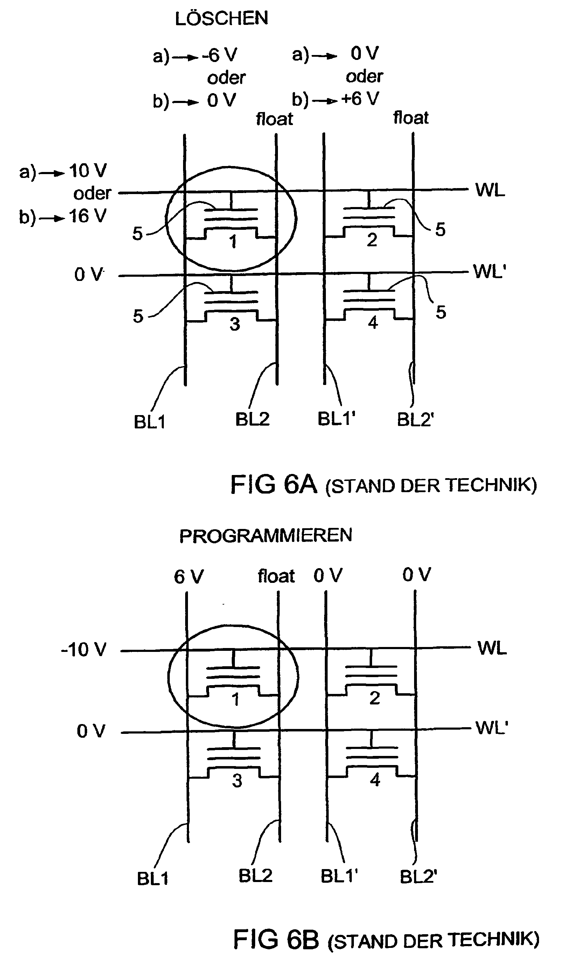

Ein Beispiel einer Architektur unter Verwendung solcher aufgeteilter Spannungen wird nachfolgend bezugnehmend auf die Fig. 6a und 6b näher erläutert, die schematisch einen Ausschnitt eines Speicherzellenarrays mit vier Speicherzellen 1, 2, 3 und 4 zeigen. In Fig. 6a sind die angelegten Spannungen für ein Löschen der eingekreisten Speicherzelle 1 gezeigt, während in Fig. 6b die angelegten Spannungen für ein Programmieren der eingekreisten Speicherzelle 1 dargestellt sind.

Bei den Speicherzellen 1 bis 4 handelt es sich beispielsweise um übliche n-Kanal-EEPROM-Speicherzellen vom Flotox-Typ (Flotox = Floating Gate Tunnel Oxide). Solche Speicherzellen weisen Tunnelinjektionsgebiete auf, die nicht dargestellt sind. Bei solchen n-Kanal-EEPROM-Zellen ist entsprechend der hierin verwendeten Terminologie das Programmieren gleichbedeutend mit dem Abziehen von Elektronen von dem Floating-Gate, während das Löschen gleichbedeutend mit dem Aufbringen von Elektronen auf das Floating-Gate ist. Zum Anlegen der erforderlichen Spannungen sind Wortleitungen und Bitleitungen vorgesehen.

Wie in den Fig. 6a und 6b gezeigt ist, sind die Steuergates 5 von in einer Reihe angeordneten Speicherzellen 1 und 2 mit einer Wortleitung WL verbunden, während die Steuergates 5 der in der darunterliegenden Reihe angeordneten Speicherzellen 3 und 4 mit einer Wortleitung WL' verbunden sind. Ferner sind die Sourcebereiche der in der linken Spalte angeordneten Speicherzellen 1 und 3 mit einer ersten Bitleitung BL1 verbunden, während die Drainbereiche derselben mit einer zweiten Bitleitung BL2 verbunden sind. In gleicher Weise sind die Sourcebereiche der in der rechten Spalte angeordneten Speicherzellen 2 und 4 mit einer ersten Bitleitung BL1' verbunden, während die Drainbereiche derselben mit einer zweiten Bitleitung BL2' verbunden sind.

Um nun selektiv eine Speicherzelle zu programmieren oder zu löschen, werden geeignete Spannungen über eine zugeordnete Wortleitung und die beiden zugeordneten Bitleitungen zugeführt, so daß nur für die Speicherzelle, die sich im jeweiligen Kreuzungspunkt der Wortleitungen und der beiden Bitleitungen befindet, sowohl am Steuergate als auch am Drainbereich eine ausreichend hohe Potentialdifferenz anliegt, um ein Löschen bzw. Programmieren der betroffenen Speicherzelle durch ein Fowler-Nordheim-Tunneln bewirken zu können. Weder das Drain-Potential allein noch das Steuergatepotential allein reichen aus, um einen solchen Tunnelvorgang zu bewirken, so daß der gewünschte Effekt lediglich bei der am Kreuzungspunkt liegenden Speicherzelle auftritt.

In Fig. 6a sind zwei Fälle a) und b) von Spannungen dargestellt, die zum Löschen der eingekreisten Speicherzelle 1 an die Wortleitungen und Bitleitungen angelegt werden.

Im ersten Fall a) liegt an der der zu löschenden Zelle 1 zugeordneten Wortleitung WL eine Spannung von +10V an und an der zugeordneten Bitleitung BL1 liegt eine Spannung von -6V an, während die zugeordnete Bitleitung BL2 floatet. An der Wortleitung WL' und der Bitleitung BL1' liegt eine Spannung von 0V an und die Bitleitung BL2' floatet.

Im zweiten Fall b) liegt an der der zu löschenden Speicherzelle 1 zugeordneten Wortleitung WL eine Spannung von +16V an und an der zugeordneten Bitleitung BL1 liegt eine Spannung von 0V an, während die zugeordnete Bitleitung BL2 floatet. An der Wortleitung WL' liegt eine Spannung von 0V an, an der Bitleitung BL1' liegt eine Spannung von +6V an, und die Bitleitung BL12' floatet.

Wie in Fig. 6b gezeigt ist, liegt zum Programmieren der ausgewählten Zelle 1 an der zugeordneten Wortleitung WL eine Spannung von -10V an, während an der zugeordneten Bitleitung BL1 eine Spannung von +6V anliegt und die zugeordnete Bitleitung BL2 floatet. Die Wortleitung WL' und die Bitleitungen BL1' und BL2' liegen jeweils auf einem Potential von 0V.

Neben den oben bezugnehmend auf die Fig. 6a und 6b beschriebenen geteilten, an Wortleitungen und Bitleitungen anzulegenden Spannungen, ist es ferner notwendig, dass die zum Löschen geeigneten Potentiale an den Tunnelfenstern der Speicherzellen anliegen. Dabei müssen beim Löschen im Fall b) positive Potentiale als sogenannte Inhibit-Spannung an das Tunnelfenster nicht zu löschender Zellen angelegt werden, während im Fall a) negative Potentiale zum Löschen an das Tunnelfenster der angesprochenen Zelle angelegt werden müssen. Negative Potentiale lassen sich im allgemeinen nicht selektiv an eine Bitleitung anlegen, da die Source/Draingebiete in Durchlassrichtung gepolt sind.

Um ein positives Potential an das Tunnelfenster heranzuführen, ist ein hochdotiertes n⁺-Injektionsgebiet unter dem Tunnelfenster erforderlich, was zu einer Flächenvergrößerung der Zelle führt. Diese Flächenvergrößerung kann reduziert werden, indem der Drain-Überlapp bzw. der Source-Überlapp als Injektionsgebiet genutzt wird, was jedoch aufgrund der hohen Stromdichte beim Löschen zu einem Zuverlässigkeitsproblem führt. Wird auf das angesprochene Injektionsgebiet gänzlich verzichtet, kann ein positives Potential an das Tunneloxid der Zelle nur über die Wanne angelegt werden. Positive Potentiale erfordern eine p-Wanne in einer tiefen n-Wanne, was eine sogenannte "Tripel Well" zur Folge hat, was die Prozeßkomplexität erhöht. Eine solche Technik unter Verwendung einer isolierten P-Wannen-Struktur für jede Zellenspalte ist bei Chi-Nan Brian Li u.a., "A Novel Uniform-Channel-Program-Erase (UCPE) Flash EEPROM Using An Isolated P-Well Structure, Conference Proceedings of IEDM 2000, San Franzisko, 10. - 13. Dezember 2000, beschrieben.

Eine individuelle Isolation von Wannen unter einer Zelle würde extrem viel Platz beanspruchen. Somit ist nur die Ansteuerung großer Speicherblöcke möglich.

Ohne die Verwendung eines Injektionsgebiets können geeignete Split-Voltage-Bedingungen beim Löschen einer Zelle noch erreicht werden, indem man ausnutzt, daß im Fall b) von Fig. 6a an der Speicherzelle 2 ein Kanal entsteht, über den das positive Potential an die Zelle herangeführt werden kann. Dies ist jedoch beim Schreiben nicht mehr möglich, da bei negativen Spannungen am Steuergate kein Kanal entsteht. Positive oder negative Spannungen müssen dann über die Wanne zugeführt werden. Somit können auch hier nur große Speicherblöcke pauschal gelöscht werden.

Falls keine aufgeteilten Spannungen angewendet werden, kann eine Hochspannung über jeweilige Bitleitungen zugeführt werden, um ein Fowler-Nordheim-Tunneln zu bewirken, wobei dann jedoch diese Hochspannung durch Auswahlgates von den nicht angesprochenen Zellen abgeblockt werden muß.

Ein Speicherzellenarray, das auf einem SOI-Wafer (SOI = silicon-on-insulator) basiert, ist in der US-5,796,142 beschrieben. Bei dem dort beschriebenen Speicherzellenarray sind die Source/Drain-Bereiche der Speichertransistoren in der Siliziumschicht eines SÖI-Wafers bis zu der isolierenden Schicht desselben gebildet. Somit ergeben sich zwischen den jeweiligen Source/Drain-Bereichen durch die Source/Drain-Bereiche voneinander getrennte streifenförmige Substratbereiche, so daß die Substratbereiche einer Reihe von Speicherzellen von den Substratbereichen einer benachbarten Reihe von Speicherzellen isoliert sind. Somit können geeignete Spannungen an die mit dem Steuergate einer jeweiligen Zelle verbundene Wortleitung und den streifenförmigen Substratbereich bzw. die Substratzeile der entsprechenden Speicherzelle angelegt werden, um basierend auf dem Fowler-Nordheim-Tunneleffekt zwischen dem Floating-Gate und dem Substrat sowohl eine Löschals auch eine Programmier-Operation zu bewirken,.

Aus der JP 09 116120 A (und den zugeordneten Patent Abstracts of Japan, Vol. 1997, Nov. 09, 30. September 1997) ist ein Speicherzellenarray bekannt, bei dem die Sourcebereiche, die Drainbereiche und die Substratbereiche entlang von Wortleitungen benachbarter Speicherzellen durch Oxidbereiche voneinander getrennt sind. In der Richtung senkrecht zu den Wortleitungen sind die Drainbereiche durchgehend als Datenleitung ausgebildet, die Sourcebereiche sind durchgehend als Source-Leitung ausgebildet und die Substratbereiche sind durchgehend als Substratleitung ausgebildet. Zum Programmieren bzw. Löschen jeweiliger Speicherzellen werden geeignete Spannungen an die Wortleitungen, Datenleitungen, Sourceleitungen und Substratleitungen angelegt.

Aus der JP 09 213910 A (und den zugeordneten Patent Abstracts of Japan, Vol. 1997, Nor. 12, 25. Dezember 1997) ist ebenfalls ein Speicherzellenarray bekannt, bei dem die Substratbereiche von entlang von Wortleitungen benachbarten Speichertransistoren durch Oxidbereiche voneinander isoliert sind. Senkrecht zu den Wortleitungen benachbarte Substratbereiche sind miteinander verbunden. Zum Programmieren und Löschen von Speicherzellen werden jeweilige Spannungen an Wortleitungen., Substratbereiche der Transistoren und Bitleitungen angelegt.

Aus der US-5,760,437 ist ein Speicherzellenarray bekannt, das auf einem Halbleitersubstrat realisiert ist, wobei die Drain/Sourcebereiche der Speicherzellen in einer Oberfläche des Halbleitersubstrats gebildet sind. Die benachbarten Speicherzellen zugeordneten Kanalsubstratbereiche sind nicht voneinander isoliert.

Die Aufgabe der vorliegenden Erfindung besteht darin, ein Speicherzellenarray und ein Verfahren zum Herstellen desselben zu schaffen, das eine einfache Programmierung und Löschung von Speicherzellen ermöglicht..

Diese Aufgabe wird durch ein Speicherzellenarray nach Anspruch 1 und ein Verfahren zum Herstellen eines Speicherzellenarrays nach Anspruch 10 gelöst.

Die vorliegende Erfindung schafft ein Speicherzellenarray mit folgenden Merkmalen:
einer Mehrzahl von in einem zweidimensionalen Array angeordneten Speichertransistoren, wobei jeder Speichertransistor zwei Source/Drain-Bereiche, die in einer ersten Richtung des Speicherzellenarrays mit einem Kanalsubstratbereich zwischen denselben angeordnet sind, und eine über dem Kanalsubstratbereich angeordnete Gatestruktur aufweist,
wobei die Source/Drain-Bereiche und die Kanalsubstratbereiche in einem auf einer isolierenden Schicht angeordneten Substrat gebildet sind und die Kanalsubstratbereiche von in der ersten Richtung benachbarten Speichertransistoren durch jeweilige Source/Drain-Bereiche, die bis zu der isolierenden Schicht reichen, voneinander getrennt sind, und
wobei die Source/Drain-Bereiche und Kanalsubstratbereiche von in einer zweiten Richtung des Speicherzellenarrays benachbarten Speichertransistoren durch in dem Substrat gebildete, bis zu der isolierenden Schicht reichende, mit einem isolierenden Material gefüllte Gräben voneinander isoliert sind.

Die vorliegende Erfindung schafft ferner ein Verfahren zum Herstellen eines Speicherzellenarrays mit folgenden Schritten:
Erzeugen von mit einem isolierenden Material gefüllten, streifenförmigen Gräben in einem auf einer isolierenden Schicht angeordneten Halbleitersubstrat, wobei die isolierenden Gräben bis zu der isolierenden Schicht reichen;
Erzeugen von im wesentlichen senkrecht zu den mit einem isolierenden Material gefüllten Gräben verlaufenden streifenförmigen Gatestrukturen, die mit den Gräben eine gitterartige Struktur bilden; und
Dotieren der zwischen der gitterartigen Struktur freibleibenden Substratbereiche zum Erzeugen von Source/Drain-Bereichen, die bis zu der isolierenden Schicht reichen.

Die vorliegende Erfindung basiert auf der Erkenntnis, daß es möglich ist, einzelne Speichertransistoren zu adressieren, ohne das Substratpotential durch einen speziellen Kontakt heranzuführen, indem das Halbleitersubstrat unter der Gatestruktur eines jeweiligen Transistors, d.h. der Kanalsubstratbereich, vollständig von dem der anderen Zellen isoliert wird. Lateral erfolgt diese Isolation durch die pn-Übergänge der Source/Drain-Bereiche, während senkrecht hierzu diese Isolation durch mit einem isolierenden Material, vorzugsweise Oxid, gefüllte Gräben erreicht wird. Die Isolation der Kanalsubstratbereiche nach unten wird durch die isolierende Schicht erreicht, bei der es sich vorzugsweise um die dicke Oxidschicht eines SOI-Wafers handelt.

Bei einem solchen Aufbau eines Speicherzellenarrays muß das Substratpotential, d.h. das Potential des Kanalsubstratbereichs, um ein Fowler-Nordheim-Tunneln zu ermöglichen, nicht durch einen speziellen Kontakt herangeführt werden, sondern erfolgt durch die Source/Drain-Kontakte unter Ausnutzung physikalischer Effekt, nämlich dem GIDL-Effekt (GIDL = Gate Induced Drain Leakage), einer in Durchlaßrichtung gepolten Diode, sowie der Kanalbildung des Speichertransistors. Somit sind keine eigenen Anschlüsse der isolierten Substratgebiete, die zu größeren Zellflächen führen würden, erforderlich. Darüber hinaus sind erfindungsgemäß weder Auswahltransistoren zum Abblocken nicht angesprochener Zellen noch Injektionsgebiete unter dem Tunnelfenster erforderlich. Vielmehr ermöglicht die vollständige Isolation der Kanalsubstratbereiche der einzelnen Speicherzellen voneinander, daß geeignete Spannungen lediglich an Wort- und Bit-Leitungen angelegt werden, um ein Adressieren von einzelnen ausgewählten Speicherzellen zu ermöglichen.

Die vorliegende Erfindung eignet sich insbesondere zur Realisierung von Speicherzellenarrays unter Verwendung von EEPROM-Zellen mit Floating-Gate, bei denen die Gatestruktur der Speichertransistoren eine Schichtfolge aus Gateoxidschicht, polykristalliner Schicht als Floating-Gate, Zwischendielektrikum, bei dem es sich vorzugsweise um eine Oxid-Nitrid-Oxid-Schichtfolge (ONO-Schichtfolge) handelt, und polykristalliner Schicht als Steuergate aufweist.

Bei einem solchen zweidimensionalen Speicherzellenarray sind die Steuergates einer Reihe von in einer Richtung angeordneten Speichertransistoren über Wortleitungen elektrisch leitfähig miteinander verbunden. Ferner sind die Source/DrainBereiche einer Reihe von in einer dazu senkrechten Richtung angeordneten Speichertransistoren über Bitleitungen verbunden, wobei erfindungsgemäß vorzugsweise für eine solche Reihe von Speichertransistoren eine erste und eine zweite Bitleitung vorgesehen sind, wobei die Source/Drain-Bereiche der Speichertransistoren der Reihe abwechselnd mit der ersten Bitleitung und der zweiten Bitleitung elektrisch leitfähig verbunden sind. Auf diese Weise können vorteilhaft geeignete Spannungen an Wortleitungen und Bitleitungen angelegt werden, um das wahlfreie Adressieren, d.h. Löschen oder Programmieren, einzelner Speicherzellen zu ermöglichen.

Durch das erfindungsgemäße Verfahren zum Herstellen eines Speicherzellenarrays werden zunächst die isolierenden Gräben in dem Halbleitersubstrat gebildet, woraufhin die Gatestrukturen erzeugt werden. Dadurch können im Anschluß die Source/Drain-Bereiche selbstjustierend dotiert werden.

Im Gegensatz zu dem in der US-5,796,142 beschriebenen Speicherzellenarray, das nur isolierte Substratzeilen aufweist, ist erfindungsgemäß ein isoliertes Substratgebiet für jede einzelne Speicherzelle vorgesehen. Somit ist die vorliegende Erfindung nicht, wie die in der US-5,796,142 beschriebene Technik lediglich auf eine "AND-virtual-ground-Architektur" anwendbar, die lediglich einen sequentiellen Datenzugriff erlaubt, der bei einem wahlfreien Zugriff eine zu hohe Zugriffszeit erfordert. Vielmehr kann erfindungsgemäß eine NORartige Architektur realisiert werden, die einen schnellen wahlfreien Zugriff ermöglicht. Ein weiterer Nachteil der in der US-5,796,142 beschriebenen Technik, der erfindungsgemäß ausgeräumt wird, liegt darin, daß der Anschluß der Substratzeile (Bodyline) nicht sichergestellt ist. Einerseits verlangt die Isolation zwischen Source/Drain-Bereichen und der Substratzeile eine dünne Siliziumschicht über dem SOI-Oxid. Andererseits muß die Siliziumschicht dick genug sein, um im Substratgebiet eine durchgehende Verarmungszone zu vermeiden. Ist die Verarmungszone tiefer als das Siliziumsubstrat, kann wegen der fehlenden oder geringen Leitfähigkeit des Substrats das Potential nicht oder nur langsam an die Zelle geführt werden. Diese Problematik tritt bei der vorliegenden Erfindung nicht auf, da das Substratpotential nicht durch einen speziellen Kontakt herangeführt werden muß.

Eine weitere Einschränkung des in der US-5,796,142 beschriebenen Speichers ergibt sich durch den geringen Koppelfaktor der Zelle, was zu sehr langen Schreib/Löschzeiten im Bereich von 20 ms bis 100 ms führt. Wenn eine Parallelisierung beim Löschen und Schreiben, d.h. ein gleichzeitiges Löschen/Schreiben vieler Zellen, nicht möglich ist, beispielsweise wenn nur ein oder wenige Bytes angesprochen werden sollen, ist dies für viele Anwendungen eine nicht tragbare Einschränkung. Schnellere Schreib/Löschzeiten könnten nur durch einen höheren Koppelfaktor und eine damit verbundene Zellflächenvergrößerung erreicht werden, wobei dann jedoch der Vorteil der "AND-virtual-ground-Architektur" hinsichtlich der maximalen Packungsdichte, verloren gehen würde.

Die vorliegende Erfindung eignet sich somit zur Realisierung eines NVM-Zellenfeld, das aus Floating-Gate-Zellen besteht, die durch Fowler-Nordheim-Tunneln gelöscht und programmiert werden können, wobei weder Injektionsgebiete unter dem Tunnelfenster noch Byteschalter benötigt werden. Die Speicherzellen können sowohl bitweise programmiert als auch bitweise gelöscht werden. Dies wird erfindungsgemäß erreicht, indem das Zellenfeld auf einem SOI-Substrat realisiert wird und jede Zelle ihr eigenes isoliertes Substratgebiet erhält. Bei einem solchen Aufbau kann das Substratpotential, d.h. das Kanalsubstratbereichspotential, durch die Bitleitungskontakte, d.h. die Source/Drain-Kontakte herangeführt werden, und muß nicht durch eigens dafür vorgesehene Substratkontakte erfolgen.

Weiterbildungen der vorliegenden Erfindung sind in den abhängigen Ansprüchen dargelegt.

Ein bevorzugtes Ausführungsbeispiel der vorliegenden Erfindung wird nachfolgend bezugnehmend auf die beiliegenden Zeichnungen näher erläutert. Es zeigen:
- Fig. 1: eine schematische perspektivische Darstellung eines erfindungsgemäßen Speicherzellenarray;
- Fig. 2: eine schematische Draufsicht auf das Speicherzellenarray von Fig. 1 ;
- Fig. 3a: und 3b schematische Darstellungen zur Veranschaulichung der für einen Löschvorgang anzulegenden Spannungen;
- Fig. 4a: und 4b schematische Darstellungen der für einen Programmiervorgang einer ausgewählten Speicherzelle anzulegenden Spannungen;
- Fig. 5: eine schematische Darstellung zur Veranschaulichung der zum Auslesen einer Speicherzelle anzulegenden Spannungen; und
- Fig. 6a: und 6b schematische Ansichten der zum Löschen und Programmieren anzulegenden Spannungen bei einem bekannten Speicherzellenarray.

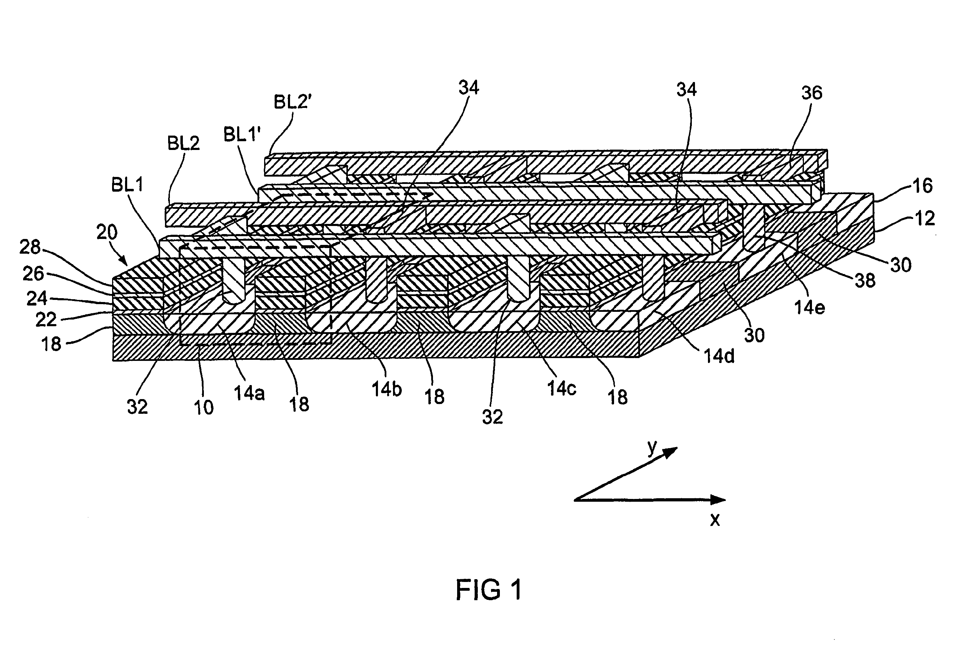

Nachfolgend wird die vorliegende Erfindung anhand eines bevorzugten Ausführungsbeispiels näher erläutert, bei dem die Speicherzellen durch Floating-Gate-EEPROM-Speicherzellen gebildet sind. Fig. 1 zeigt eine schematische perspektivische Ansicht eines solchen erfindungsgemäßen Speicherzellenarrays, wobei in Fig. 1 eine einzelne Speicherzelle durch einen gestrichelten Rahmen 10 angedeutet ist.

Das erfindungsgemäße Speicherzellenarray ist auf einer isolierenden Schicht 12 aufgebaut, bei der es sich vorzugsweise um eine Oxidschicht eines SOI-Wafers handelt. Source/DrainBereiche 14a, 14b, 14c und 14d sind in einer auf der isolierenden Schicht 12 angeordneten Halbleiterschicht 16 gebildet, bei der es sich vorzugsweise um die Siliziumschicht eines SOI-Wafers handelt. Durch die Source/Drain-Bereiche sind ferner jeweilige Kanalsubstratbereiche 18 in der Halbleiterschicht 16 definiert. Über den Kanalsubstratbereichen 18 sind jeweilige Gatestrukturen 20 gebildet, die bei dem dargestellten Ausführungsbeispiel aus einem Gatestapel bestehen, der eine Gateoxidschicht 22, eine polykristalline Siliziumschicht 24 als Floating-Gate, ein Zwischendielektrikum 26 und eine polykristalline Siliziumschicht 28 als Steuergate aufweist. Das Zwischendielektrikum 26 ist vorzugsweise durch eine ONO-Schichtfolge (ONO = Oxid-Nitrid-Oxid) gebildet.

Die in Fig. 1 mit dem Rahmen 10 versehene Speicherzelle ist somit durch einen Sourcebereich 14a, einen Drainbereich 14b, einen zwischen denselben angeordneten Kanalsubstratbereich 18 und die auf dem Kanalbereich 18 angeordneten Gatestruktur 20 gebildet. Die Source/Drain-Bereiche 14a und 14b sind vorzugsweise n⁺-dotiert, während die Halbleiterschicht 16 vorzugsweise eine p-Schicht ist, so daß die Kanalsubstratbereiche 18 ebenfalls p-Bereiche sind.

Wie ferner in Fig. 1 zu sehen ist, sind die Kanalsubstratbereiche 18 von in x-Richtung benachbarten Speicherzellen 10 durch die jeweiligen Source/Drain-Bereiche 14a, 14b, 14c und 14d, die bis zu der isolierenden Schicht 12 reichen, voneinander getrennt. Ferner sind die Kanalsubstratbereiche von in γ-Richtung benachbarten Speicherzellen 10 durch mit einem isolierenden Material, vorzugsweise Oxid, gefüllte Gräben, die ebenfalls bis zu der isolierenden Schicht 12 reichen, voneinander isoliert. Die isolierenden Gräben durchziehen die Halbleiterschicht 16 vollständig in x-Richtung, derart, daß die Kanalsubstratbereiche 18 und Source/Drain-Bereiche sämtlicher in γ-Richtung benachbarter Speicherzellen voneinander isoliert sind, wie in Fig. 1 anhand des Source/Drain-Bereichs 14d und des in γ-Richtung benachbarten Source/Drain-Bereichs 14e zu sehen ist.

Die Gatestrukturen 20 sind derart ausgebildet, daß dieselben über den Kanalsubstratbereichen jeweils einer Reihe von in γ-Richtung angeordneten Speicherzellen angeordnet sind. Bei dieser Konfiguration stellen die Steuergates der in einer solchen Reihe in γ-Richtung angeordneten Speicherzellen jeweilige Wortleitungen WL dar. An dieser Stelle sei angemerkt, daß es, um diese Wortleitungen niederohmig zu gestalten, üblich ist, die aus Polysilizium gebildeten Steuergatebereiche mit einer metallischen Schicht (nicht gezeigt) zu versehen.

Wie ferner in Fig. 1 gezeigt ist, sind bei dem bevorzugten Ausführungsbeispiel der vorliegenden Erfindung für jede in x-Richtung angeordnete Reihe von Speicherzellen zwei Bitleitungen BL1 und BL2 vorgesehen, wobei die Source/Drain-Bereiche 14a, 14b, 14c und 14d abwechselnd mit den Bitleitungen BL1 und BL2 verbunden sind. Dadurch ist jeweils ein Source/DrainBereich einer Speicherzelle mit der ersten Bitleitung BL1 verbunden und der andere Source/Drain-Bereich der gleichen Speicherzelle ist mit der zweiten Bitleitung BL2 verbunden. Spezieller ist bei der mit dem Rahmen 10 versehenen Speicherzelle der Sourcebereich 14a mit der ersten Bitleitung BL1 verbunden, während der Drainbereich 14b mit der zweiten Bitleitung BL2 verbunden ist. Für die in Fig. 1 in y-Richtung benachbarte Reihe von Speicherzellen sind in gleicher Weise zwei Bitleitungen BL1' und BL2' vorgesehen.

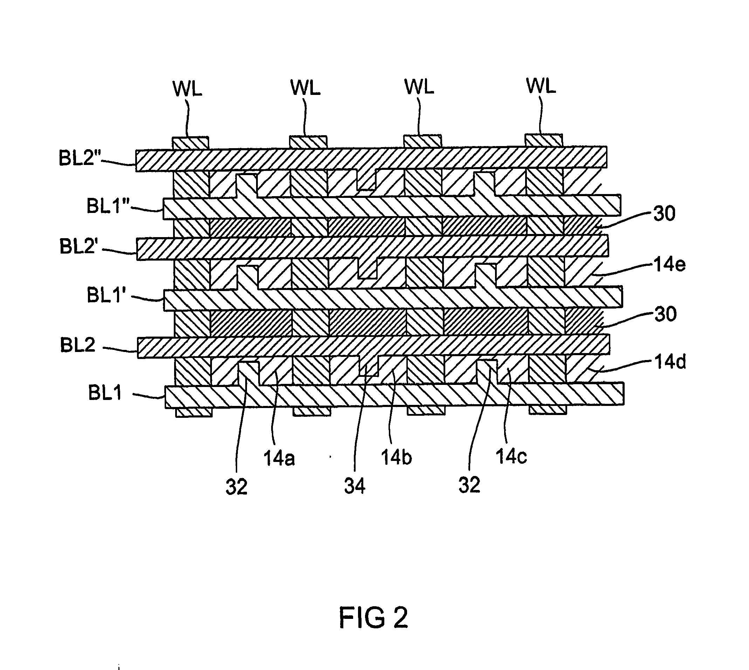

Hinsichtlich der sich ergebenden Struktur sei ferner auf die in Fig. 2 dargestellte Draufsicht verwiesen, die ferner erste und zweite Bitleitungen BL1" und BL2" für eine dritte Reihe von Speicherzellen zeigt.

Wie gezeigt ist, ist die erste Bitleitung BL1 durch leitfähige, beispielsweise metallische, Verbindungseinrichtungen 32 mit den Source/Drain-Bereichen 14a und 14c verbunden, während die zweite Bitleitung BL2 über leitfähige Verbindungseinrichtungen 34 mit den Source/Drain-Bereichen 14b und 14c verbunden ist. Die metallischen Verbindungseinrichtungen 32, 34 sind lediglich schematisch dargestellt und weisen bei dem dargestellten Ausführungsbeispiel sich seitlich erstreckende Verbindungsabschnitte, von denen einer beispielhaft mit dem Bezugszeichen 36 bezeichnet ist, und vertikale Durchkontaktiersabschnitte, von denen einer beispielhaft mit dem Bezugszeichen 38 bezeichnet ist, auf. An dieser Stelle sei jedoch angemerkt, daß die diesbezüglichen Darstellungen in den Fig. 1 und 2 lediglich schematischer Natur sind, wobei es für einen Fachmann klar ist, daß die Verbindungseinrichtungen 32, 34 eine beliebige geeignete Form aufweisen können und unter Verwendung beliebiger geeigneter Techniken hergestellt werden können, um jeweils abwechselnd Source/Drain-Bereiche mit einer ersten bzw. zweiten Bitleitung zu verbinden. An dieser Stelle sei ferner angemerkt, daß aus Gründen der Übersichtlichkeit in den Fig. 1 und 2 isolierendes Material, das bei dem Speicherzellenarray zwischen den Gatestrukturen 28 und zwischen den Bitleitungen und Wortleitungen zur Isolierung derselben voneinander vorgesehen ist, nicht dargestellt ist.

Nachdem nun ein Beispiel eines erfindungsgemäßen Speicherzellenarrays anhand des in den Fig. 1 und 2 dargestellten Abschnitts beschrieben wurde, sei angemerkt, daß das erfindungsgemäße Speicherzellenarray unter Verwendung herkömmlicher Verfahrensschritte hergestellt werden kann. Bezüglich des Herstellungsverfahrens für das erfindungsgemäße Speicherzellenarray sei lediglich angemerkt, daß die isolierenden Gräben 30 ebenfalls unter Verwendung herkömmlicher Techniken erzeugt werden können. Die Gräben werden erfindungsgemäß vorzugsweise vor der Erzeugung der Gatestrukturen 28 in die Halbleiterschicht 16 geätzt und nachfolgend mit einem isolierenden Material, beispielsweise Oxid, gefüllt. Beliebige Verfahren zur Planarisierung nach dem Füllen der Gräben mit dem isolierenden Material können verwendet werden. Derartige Verfahren sind als STI-Verfahren (STI = shallow trench isolation) bekannt. Alternativ können Feldoxid-Isolationsverfahren verwendet werden, um die mit einem isolierenden Material gefüllten Gräben zu erzeugen. Im Anschluß an die Erzeugung der Gatestrukturen können dann die durch die Gitterstruktur aus isolierenden Gräben und Gatestrukturen freigelassenen Substratbereiche selbstjustiert dotiert werden, um die Source/Drainbereiche zu erzeugen.

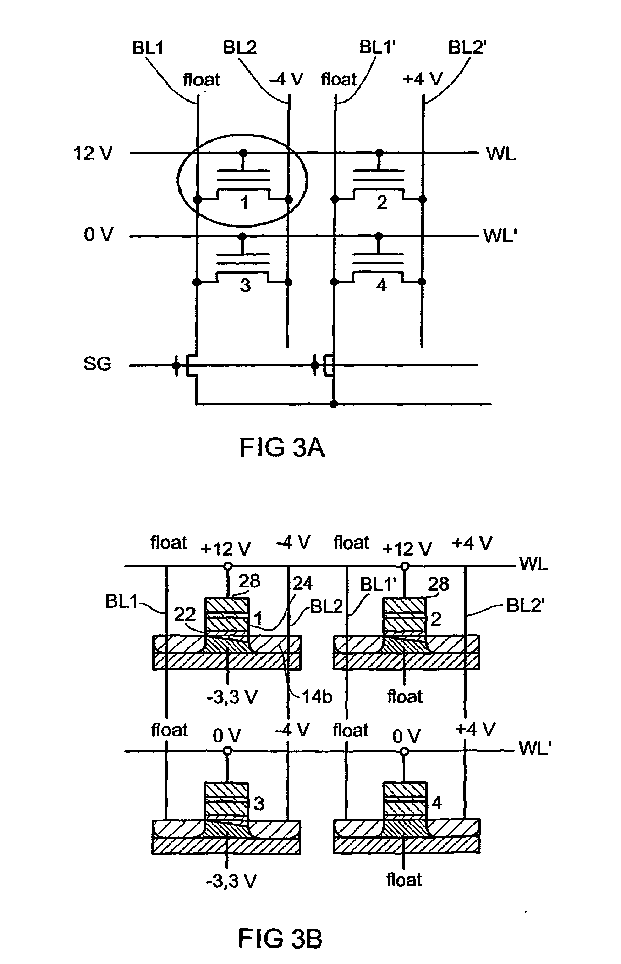

Im folgenden wird bezugnehmend auf die Fig. 3a, 3b, 4a, 4b und 5 gezeigt, wie bei dem erfindungsgemäßen Speicherzellenarray ein Löschen, Programmieren und Lesen bitweise erfolgen kann.

In Fig. 3a ist das Ersatzschaltbild mit den angelegten Potentialen für einen Lösch-Vorgang der eingekreisten Speicherzelle 1 dargestellt. In Fig. 3b ist im wesentlichen das gleiche Schaltbild gezeigt, wobei jedoch die Transistoren der Speicherzellen 1 bis 4 im Querschnitt dargestellt sind, um die physikalischen Vorgänge anschaulicher zu machen. In Fig. 3a sind die die ausgewählte Speicherzelle, die gelöscht werden soll, betreffenden erste und zweite Bitleitung mit BL1 und BL2 bezeichnet, während die Bitleitungen der in y-Richtung benachbarten Speicherzellen mit BL1' und BL2' bezeichnet sind.

Die Bitleitung BL1 ist mit den Sourcebereichen der Speicherzellen 1 und 3 verbunden, während die Bitleitung BL2 mit den Drainbereichen dieser Speicherzellen verbunden ist. Die Bitleitung BL1' ist mit den Sourcebereichen der Speicherzellen 2 und 4 verbunden, während die Bitleitung BL2` mit den Drainbereichen dieser Speicherzellen verbunden ist.

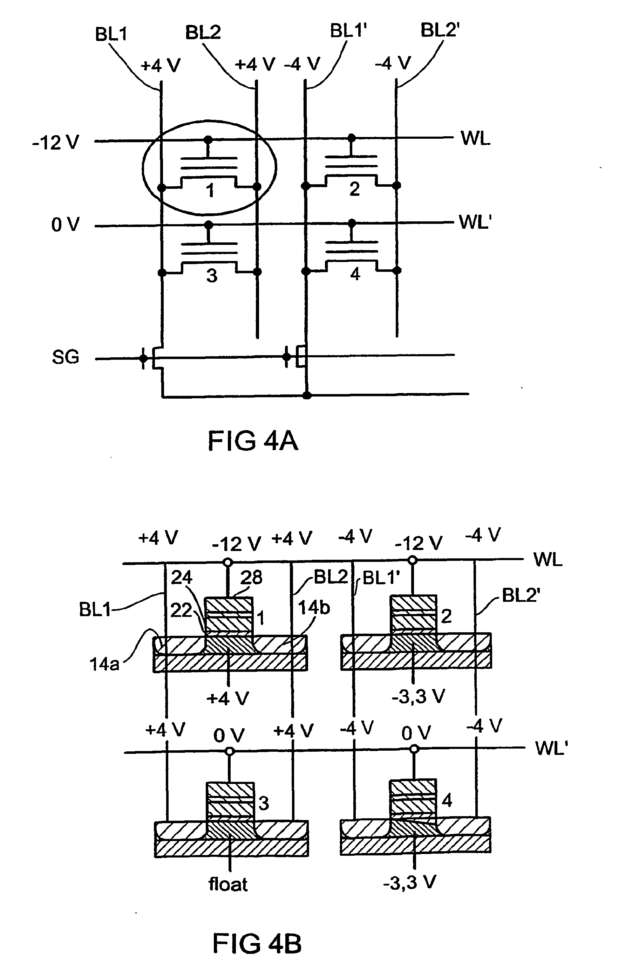

Ferner ist die die ausgewählte Speicherzelle betreffende Wortleitung, die mit den Steuergates der Speicherzellen 1 und 2 verbunden ist, mit WL bezeichnet, während die benachbarte Wortleitung, die mit den Steuergates der Speicherzellen 3 und 4 verbunden ist, mit dem Bezugszeichen WL' bezeichnet ist. Diese Terminologie ist auch in den Fig. 3b, 4a und 4b verwendet. Schließlich sind in dem Ersatzschaltbild der Fig. 3a schematisch beispielhafte Auswahlgates (SG; SG = Select Gate) dargestellt, die dazu dienen, die jeweiligen Bitleitungen floatend zu schalten. Wie derartige Auswahlgates sowie die weitere Peripherie des Speicherzellenarray, beispielsweise um geeignete Spannungen anzulegen, auszugestalten ist, ist für Fachleute klar und muß daher an dieser Stelle nicht weiter erläutert werden.

Bevor auf die zum Löschen, Programmieren und Lesen einer ausgewählten Speicherzelle verwendeten Spannungen im einzelnen eingegangen wird, sei darauf hingewiesen, daß sich diese Spannungen auf n-Kanal-Speichertransistoren beziehen, wie sie üblicherweise verwendet werden. Es ist jedoch klar, daß die Polaritäten der Spannungen umgekehrt werden können, um in analoger Weise das Löschen, Programmieren und Lesen von p-Kanal-Speicherzellen zu bewirken.

Um eine ausgewählte Speicherzelle, in Fig. 3 die mit dem Kreis markierte Speicherzelle 1, zu löschen, wird durch eine geeignete Treibereinrichtung eine Spannung von +12V an die Wortleitung WL angelegt. Ferner wird eine Spannung entgegengesetzter Polarität von -4V an die Bitleitung BL2 angelegt. Die mit dem Sourcebereich dieser Speicherzelle 1 verbundene Bitleitung BL1 floatet. Da der pn-Übergang vom Drainbereich zum Substrat, d. h. zum Kanalsubstratbereich, dieser Speicherzelle bei diesen anliegenden Spannungen bzw. Potentialen in Durchlaßrichtung gepolt ist, lädt sich das Substrat der Speicherzelle 1 auf ca. -3,3V auf, wie in Fig. 3b gezeigt ist. Wegen des reversen Substratsteuereffekts, d.h. der Absenkung der Einsatzspannung, wenn das Substrat relativ zum Drainbereich positiv vorgespannt ist, bildet sich unter dem Gateoxid 22 des Speichertransistors 1 ein Kanal 40. Der Kanal 40 liegt also auf dem gleichen Potential wie der Drainbereich 14b, der mit der Bitleitung BL2 verbunden ist. Die gesamte Potentialdifferenz zwischen Steuergate 28, das durch die Wortleitung WL auf +12V liegt, und Kanal 40 beträgt also 12V - (-4V) = 16V. Somit tunneln Elektroden durch das Gateoxid 22 auf das Floating-Gate 24 der Speicherzelle 1.

Bei der nicht angesprochenen Speicherzelle 2, deren Steuergate ebenfalls mit der Wortleitung WL verbunden und somit auf einem Potential von +12V liegt, setzt das positive Potential +4V, das über die Bitleitung BL2' an dem Drainbereich der Speicherzelle 2 anliegt, die Spannungsdifferenz so weit herab, daß ein Tunneln nicht mehr eintritt. Die positive Spannung von +4V, die an der zweiten Bitleitung BL2' anliegt, stellt eine sogenannte Inhibit-Spannung dar, um störende, unerwünschte Tunneleffekte in nicht angesprochenen Speicherzellen, deren Steuergates mit der gleichen Wortleitung wie die angesprochene Speicherzelle verbunden sind, aufgrund des an dieser Wortleitung anliegenden Potentials zu verhindern. Die erste Bitleitung BL1' der nicht angesprochenen Speicherzelle 2 floatet.

Für die nicht angesprochenen Speicherzellen 3 und 4 liegen die Spannungen, d.h. die Potentialdifferenzen zwischen Steuergate und Substrat bzw. Kanal noch niedriger, so daß auch hier kein Tunneln und somit kein Löschen auftritt. Somit wird als einziges die ausgewählte Speicherzelle 1 durch die angelegten beschriebenen Spannungen gelöscht.

Bezugnehmend auf die Fig. 4a und 4b werden nun die zum Programmieren eines ausgewählten Speicherzelle, d.h. zum Abziehen von Ladungen von dem Floating-Gate derselben, durch eine geeignete Treibereinrichtung angelegten Spannungen beschrieben.

Zum Programmieren der ausgewählten Speicherzelle 1 liegt die mit dem Steuergate 28 derselben verbundene Wortleitung WL auf einem Potential von -12V, während die mit dem Sourcebereich der Speicherzelle 1 verbundene Bitleitung BL1 und die mit dem Drainbereich der Speicherzelle 1 verbundene Bitleitung BL2 auf einem Potential von +4V liegt. Der pn-Übergang vom Drainbereich 14b zum Substrat 18 ist jetzt in Sperrichtung gepolt. Das Substrat lädt sich aber trotzdem auf das Drainpotential von +4V auf, da an der Drainkante Band-Zu-Band-Tunneln eintritt, das allgemein als GIDL (GIDL = Gate Induced Drain Leakage) bezeichnet wird. Das bedeutet, daß an der Drainbereichskante Löcher generiert werden, welche vom positiven Drainbereich weg zum Substrat hin abfließen, bis sich dieses auf das Drainpotential von +4V aufgeladen hat. Die gesamte Potentialdifferenz zwischen Steuergate 28 und Substrat bzw. Substratkanalbereich 18 beträgt also -12V -(+4V) = -16V. Folglich tunneln Elektroden vom Floating-Gate 24 über das Gateoxid 22 in das Substrat. Wesentlich hierbei ist, daß ein definiertes Substratpotential ohne Substratkontakt allein durch den GIDL-Effekt eingestellt werden kann, so daß ohne einen Substratkontakt ein Programmieren einer ausgewählten Speicherzelle bewirkt werden kann.

Die erste Bitleitung BL1', die mit dem Sourcebereich der nicht angesprochenen Speicherzelle 2 verbunden ist, und die zweite Bitleitung BL2', die mit dem Drainbereich der nicht angesprochenen Speicherzelle 2 verbunden ist, liegen jeweils auf einem Potential von -4V. Dadurch ist die Substrat-Drain-Diode in Durchlaßrichtung gepolt, wodurch sich das Substrat negativ auflädt und das Einsetzen eines Tunnelns von dem Floating-Gate verhindert. Für die nicht angesprochenen Zellen 3 und 4, die nicht programmiert werden sollen, liegen die Spannungen noch niedriger als in der Zelle 2, so daß auch hier kein Programmieren auftritt. Es ist somit erfindungsgemäß möglich, ohne Vorsehen von Substratkontakten Speicherzellen bitweise, d.h. einzeln, zu programmieren.

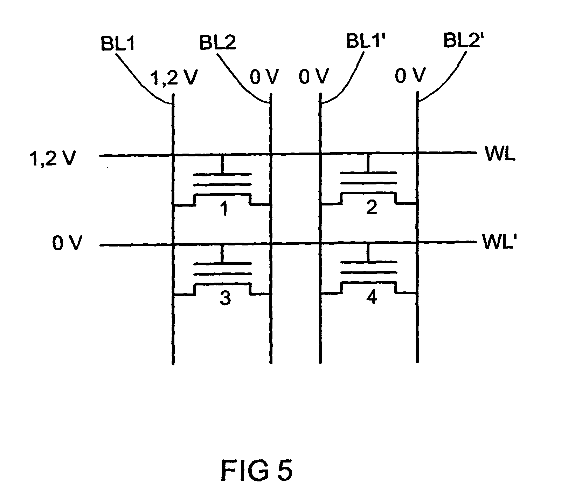

Zum bitweisen Lesen einer ausgewählten Speicherzelle, hier Speicherzelle 1, wird in üblicher Weise eine geeignete Spannung an das Steuergate der auszulesenden Speicherzelle angelegt, während gleichzeitig eine geeignete Source/Drain-Potentialdifferenz angelegt wird. Dies ist in Fig. 5 dargestellt, die ein Potential von 1,2V an der Wortleitung WL und ein Potential von 1,2V an der ersten Bitleitung BL1 zeigt. Die Potentiale beim Lesen müssen derart gewählt sein, daß ein Tunneln auf oder von dem Floating-Gate bei den gewählten Spannungen nicht auftritt. Wie bei üblichen Speicherzellen, stellt während des Lesens der Kanalstrom bei einem vorgegebenen Gatepotential das Entscheidungskriterium dar, ob eine Zelle gelöscht oder programmiert ist.

Das oben beschriebene Speicherzellenarray ermöglicht somit einen wahlfreien Zugriff auf einzelne Speicherzellen des Arrays, wobei durch die beschriebenen Inhibitspannungen Störungen, die in Fachkreisen als sogenannte Disturbs bezeichnet werden, der nicht angesprochenen Zellen minimiert bzw. beseitigt werden können. Soll jedoch auf bestimmte Zellen besonders häufig zugegriffen werden, so daß häufige Lösch- und Programmier-Vorgänge dieser Zellen stattfinden, ohne nichtangesprochene Zellen zu löschen bzw. zu programmieren, kann den sich dadurch summierenden Disturbs hinsichtlich der nicht-angesprochenen Zellen durch das zusätzliche Vorsehen von Auswahl-Gates oder durch Softwarelösungen, beispielsweise Emulationen, entgegengewirkt werden.

### Bezugszeichenliste

- WL, WL': Wortleitung
- BL1, BL1`, BL": erste Bitleitung
- BL2, BL2`, BL": zweite Bitleitung
- 1, 2, 3, 4: Speicherzellen
- 5: Steuergates
- 10: Speicherzellenrahmen
- 12: isolierende Schicht
- 14a, 14b, 14c, 14d, 14e: Source/Drain-Bereiche
- 16: Halbleiterschicht
- 18: Kanalsubstratbereiche
- 20: Gatestrukturen
- 22: Gateoxidschicht
- 24: Floating-Gate
- 26: Zwischendielektrikum
- 28: Steuergate
- 30: isolierende Gräben
- 32, 34: leitfähige Verbindungseinrichtungen
- 36: seitliche Verbindungsabschnitte
- 38: Durchkontaktierungsabschnitt
- 40: Kanal

## Patentansprüche

1. Speicherzellenarray mit folgenden Merkmalen:
einer Mehrzahl von in einem zweidimensionalen Array angeordneten Speichertransistoren (1, 2, 3, 4), wobei das zweidimensionale Array durch eine erste Richtung und eine zweite Richtung, die im wesentlichen senkrecht zur ersten Richtung ist, definiert ist, wobei jeder Speichertransistor (1, 2, 3, 4) zwei Source/Drain-Bereiche (14a, 14b, 14c, 14d), die in einer ersten Richtung des Speicherzellenarrays mit einem Kanalsubstratbereich (18) zwischen denselben angeordnet sind, und eine über dem Kanalsubstratbereich (18) angeordnete Gatestruktur (20) aufweist,
wobei die Source/Drain-Bereiche (14a, 14b, 14c, 14d) und die Kanalsubstratbereiche (18) in einem auf einer isolierenden Schicht (12) angeordneten Substrat (16) gebildet sind und die Kanalsubstratbereiche (18) von in der ersten Richtung benachbarten Speichertransistoren durch jeweilige Source/DrainBereiche, die bis zu der isolierenden Schicht (12) reichen, voneinander getrennt sind,
**dadurch gekennzeichnet,**
**dass** die Source/Drain-Bereiche (14a, 14b, 14c, 14d) und Kanalsubstratbereiche (18) von in einer zweiten Richtung des Speicherzellenarrays benachbarten Speichertransistoren durch in dem Substrat (16) gebildete, bis zu der isolierenden Schicht (12) reichende, mit einem isolierenden Material gefüllte Gräben (30) voneinander isoliert sind, und
**dass** in der ersten Richtung benachbarte Speichertransistoren einen gemeinsamen Source/Drainbereich (14a, 14b, 14c, 14d) aufweisen.

2. Speicherzellenarray nach Anspruch 1, bei dem die Source/Drain-Bereiche (14a, 14b, 14c und 14d) und die Kanalsubstratbereiche (18) in der Siliziumschicht eines SOI-Wafers gebildet sind.

3. Speicherzellenarray nach Anspruch 1, bei dem die Gatestruktur (20) der Speichertransistoren (1, 2, 3, 4) aus einer Schichtfolge besteht, die eine isolierende Gateschicht (22), ein Floating-Gate (24) auf der isolierenden Gateschicht (22), ein Zwischendielektrikum (26) auf dem Floating-Gate (24) und ein Steuergate (28) auf dem Zwischendielektrikum (26) aufweist.

4. Speicherzellenarray nach Anspruch 3, das ferner Wortleitungen (WL, WL') aufweist, die mit Steuergates (28) einer Reihe von in der zweiten Richtung angeordneten Speichertransistoren elektrisch leitfähig verbunden sind.

5. Speicherzellenarray nach Anspruch 4, das ferner Bitleitungen (BL1, BL2, BL1', BL2') aufweist, wobei einer jeweiligen Reihe von in der ersten Richtung angeordneten Speichertransistoren eine erste und eine zweite Bitleitung zugeordnet sind und wobei die Source/Drain-Bereiche (14a, 14b, 14c, 14d) der Speichertransistoren der Reihe abwechselnd mit der ersten Bitleitung (BL1) und der zweiten Bitleitung (BL2) elektrisch leitend verbunden sind.

6. Speicherzellenarray nach Anspruch 5, das ferner eine Einrichtung zum Einbringen von Ladungen auf das Floating-Gate (24) eines ausgewählten Speichertransistors (1) des Speicherzellenarrays aufweist, die ausgelegt ist, um ein Potential mit einer ersten Polarität, bei der ein Kanal (40) in dem Kanalsubstratbereich erzeugt wird, an die Wortleitung (WL), die mit dem Steuergate (28) des ausgewählten Speichertransistors (1) verbunden ist, und ein Potential mit einer zweiten zu der ersten Polarität entgegengesetzten Polarität an einen der Source/Drain-Bereiche (14b) des ausgewählten Speichertransistors (1) anzulegen, um Ladungen auf das Floating-Gate (24) des ausgewählten Speichertransistors (1) zu bringen.

7. Speicherzellenarray nach Anspruch 6, bei dem die Einrich-, tung zum Einbringen von Ladungen ferner ausgelegt ist, um ein Potential der ersten Polarität an einen der Source/DrainBereiche der Speichertransistoren (2) mit Ausnahme des ausgewählten Speichertransistors anzulegen, deren Steuergates mit der Wortleitung (WL) verbunden sind, die mit dem Steuergate des ausgewählten Speichertransistors (1) verbunden ist.

8. Speicherzellenarray nach Anspruch 7, das ferner eine Einrichtung zum Entfernen von Ladungen von dem Floating-Gate (24) eines ausgewählten Speichertransistors (1) aufweist, die ausgelegt ist, um ein Potential der zweiten Polarität an die mit dem Steuergate (28) des ausgewählten Speichertransistors (1) verbundene Wortleitung (WL) anzulegen und ein Potential der ersten Polarität an beide Source/Drain-Bereiche (14a, 14b) des ausgewählten Speichertransistors (1) anzulegen, um Ladungen von dem Floating-Gate (24) des ausgewählten Speichertransistors (1) zu entfernen.

9. Speicherzellenarray nach Anspruch 8, bei dem die Einrichtung zum Entfernen von Ladungen ferner ausgelegt ist, um ein Potential der zweiten Polarität an die Source/Drain-Bereiche der Speichertransistoren (2) mit Ausnahme des ausgewählten Speichertransistors (1), deren Steuergates mit der Wortleitung (WL) verbunden sind, die mit dem Steuergate (28) des ausgewählten Transistors (1) verbunden ist, anzulegen.

10. Herfahren zum Herstellen eines Speicherzellenarrays nach einen der Ansprüche 1 bis 9 mit folgenden Schritten:
Erzeugen von mit einem isolierenden Material gefüllten, streifenförmigen Gräben (30) in einem auf einer isolierenden Schicht (12) angeordneten Halbleitersubstrat (16), wobei die isolierenden Gräben bis zu der isolierenden Schicht (12) reichen;
Erzeugen von im wesentlichen senkrecht zu den mit einem isolierenden Material gefüllten Gräben (30) verlaufenden streifenförmigen Gatestrukturen (20), die mit den Gräben (30) eine gitterartige Struktur bilden; und
Dotieren der zwischen der gitterartigen Struktur freibleibenden Substratbereiche zum Erzeugen von Source/Drain-Bereichen (14a, 14b, 14c, 14d), die bis zu der isolierenden Schicht (12) reichen,
wobei in Richtung der Gräben (30) benachbarte Speichertransistoren einen gemeinsamen Source/Drainbereich (14a, 14b, 14c, 14d) aufweisen.

11. Verfahren nach Anspruch 10, das ferner folgende Schritte aufweist:
Erzeugen von Wortleitungen auf den Gatestrukturen; und
Erzeugen von Bitleitungen (BL1, BL2, BL1', BL2'), wobei einer Reihe von in Richtung der mit einem isolierenden Material gefüllten Gräben (30) angeordneten Source/Drain-Bereichen (14a, 14b, 14c, 14d) jeweils eine erste und eine zweite Bitleitung (BL1, BL2) zugeordnet sind und die Source/Drain-Bereiche abwechselnd mit der ersten (BL1) und der zweiten (BL2) Bitleitung verbunden sind.

## Claims

1. A memory cell array, comprising:
a plurality of memory transistors (1, 2, 3, 4) arranged in a two-dimensional array, wherein the two-dimensional array is defined by a first direction and a second direction that is essentially perpendicular to the first direction, each memory transistor (1, 2, 3, 4) having two source/drain regions (14a, 14b, 14c, 14d) arranged in a first direction of the memory cell array with a channel substrate region (18) therebetween, and a gate structure (20) arranged above the channel substrate region (18),
said source/drain regions (14a, 14b, 14c, 14d) and channel substrate regions (18) being formed in a substrate (16) arranged on an insulating layer (12), and the channel substrate regions (18) of memory transistors adjacent each other in the first direction being separated from each other by respective source/drain regions extending down to the insulating layer (12),
**characterized in that**
said source/drain regions (14a, 14b, 14c, 14d) and channel substrate regions (18) of memory transistors adjacent each other in a second direction of the memory cell array are isolated from each other by trenches (30) filled with insulating material and formed in the substrate (16) so as to extend down to the insulating layer (12), and
memory transistors adjacent each other in the first direction comprise a common source/drain region (14a, 14b, 14c, 14d).

2. A memory cell array according to claim 1,
wherein the source/drain regions (14a, 14b, 14c and 14d) and the channel substrate regions (18) are formed in the silicon layer of an SOI wafer.

3. A memory cell array according to claim 1,
wherein the gate structure (20) of the memory transistors (1, 2, 3, 4) consists of a layer sequence comprising an insulating gate layer (22), a floating gate (24) on the insulating gate layer (22), an intermediate dielectric (26) on the floating gate (24) and a control gate (28) on the intermediate dielectric (26).

4. A memory cell array according to claim 3,
further comprising word lines (WL, WL') connected in electrically conductive manner to control gates (28) of a row of memory transistors arranged in said second direction.

5. A memory cell array according to claim 4,
further comprising bit lines (BL1, BL2, BL1', BL2'), with a respective row of memory transistors arranged in the first direction having first and second bit lines associated therewith and the source/drain regions (14a, 14b, 14c, 14d) of the memory transistors of the row being connected in electrically conducting manner to the first bit line (BL1) and the second bit line (BL2) in alternating fashion.

6. A memory cell according to claim 5,
further comprising a means for introducing charges to the floating gate (24) of a selected memory transistor (1) of the memory cell array, which is implemented to apply a potential of a first polarity, at which a channel (40) is formed in the channel substrate region, to the word line (WL) connected to the control gate (28) of the selected memory transistor (1), and to apply a potential of a second polarity opposite to said first polarity to one of the source/drain regions (14b) of the selected memory transistor (1) in order to bring charges to the floating gate (24) of the selected memory transistor (1).

7. A memory cell array according to claim 6,
wherein said means for introducing charges is furthermore implemented to apply a potential of said first polarity to one of the source/drain regions of the memory transistors (2) - excluding the selected memory transistor - having their control gates connected to the word line (WL) that is connected to the control gate of the selected memory transistor (1).

8. A memory cell array according to claim 7,
further comprising a means for removing charges from the floating gate (24) of a selected memory transistor (1), which is implemented to apply a potential of said second polarity to the word line (WL) connected to the control gate (28) of the selected memory transistor (1) and to apply a potential of said first polarity to both source/drain regions (14a, 14b) of the selected memory transistor (1) in order to remove charges from the floating gate (24) of the selected memory transistor (1).

9. A memory cell array according to claim 8,
wherein said means for removing charges is furthermore implemented to apply a potential of said second polarity to the source/drain regions of the memory transistors (2) - excluding the selected memory transistor (1) - having their control gates connected to the word line (WL) that is connected to the control gate (28) of the selected transistor (1).

10. A method of making a memory cell array according to one of claims 1 to 9, comprising the steps of:
forming strip-shaped trenches (30), filled with insulating material, in a semiconductor substrate (16) arranged on an insulating layer (12), said insulating trenches extending down to the insulating layer (12);
forming strip-shaped gate structures (20) which extend substantially perpendicularly to the trenches (30) filled with insulating material and, together with said trenches (30), constitute a grid-like structure; and
doping the substrate regions left free between the grid-like structure so as to form source/drain regions (14a, 14b, 14c, 14d) extending down to the insulating layer (12),
wherein memory transistors adjacent each other in the direction of the trenches (30) comprise a common source/drain region (14a, 14b, 14c, 14d).

11. A method according to claim 10,
further comprising the steps of:
forming word lines on the gate structures; and
forming bit liens (BL1, BL2, BL1', BL2'), with a first and a second bit line (BL1, BL2) each being associated with a row of source/drain regions (14a, 14b, 14c, 14d) arranged in the direction of the trenches (30) filled with insulating material, and the source/drain regions being connected in alternating fashion to said first (BL1) and second (BL2) bit lines.

## Revendications

1. Réseau de cellules de mémoire, aux caractéristiques suivantes:
une pluralité de transistors de mémoire (1, 2, 3, 4) disposés dans un réseau bidimensionnel, le réseau bidimensionnel étant défini par une première direction et une deuxième direction sensiblement perpendiculaire à la première direction, chaque transistor de mémoire (1, 2, 3, 4) présentant deux zones de source/drain (14a, 14b, 14c, 14d) qui sont disposées selon une première direction du réseau de cellules de mémoire avec une zone de substrat à canal (18) entre ces dernières, et une structure de porte (20) disposée au-dessus de la zone de substrat à canal (18),
les zones de source/drain (14a, 14b, 14c, 14d) et les zones de substrat à canal (18) étant formées dans un substrat (16) disposé dans une couche isolante (12) et les zones de substrat à canal (18) de transistors de mémoire adjacents dans la première direction étant séparées l'une de l'autre par des zones de source/drain respectives qui s'étendent jusqu'à la couche isolante (12),
**caractérisé par le fait**
**que** les zones de source/drain (14a, 14b, 14c, 14d) et les zones de substrat de canal (18) de transistors de mémoire adjacents dans une deuxième direction de réseau de cellules de mémoire sont isolées l'une de l'autre par des fossés (30) remplis d'un matériau isolant formés dans le substrat (16) et s'étendant jusqu'à la couche isolante (12), et
**que** les transistors de mémoire adjacents dans la première direction présentent une zone de source/drain commune (14a, 14b, 14c, 14d).

2. Réseau de cellules de mémoire selon la revendication 1, dans lequel les zones de source/drain (14a, 14b, 14c et 14d) et les zones de substrat à canal (18) sont formées dans la couche de silicium d'une plaquette SOI.

3. Réseau de cellules de mémoire selon la revendication 1, dans lequel la structure de porte (20) des transistors de mémoire (1, 2, 3, 4) consiste en une succession de couches qui présente une couche de porte isolante (22), une porte flottante (24) sur la couche de porte isolante (22), un diélectrique intermédiaire (26) sur la porte flottante (24) et une porte de commande (28) sur le diélectrique intermédiaire (26).

4. Réseau de cellules de mémoire selon la revendication 3, présentent par ailleurs des lignes de mot (WL, WL') qui sont reliées de manière électro-conductrice à des portes de commande (28) d'une rangée de transistors de mémoire disposés dans la deuxième direction.

5. Réseau de cellules de mémoire selon la revendication 4, présentant par ailleurs des lignes de bits (BL1, BL2, BL1', BL2'), à une rangée respective de transistors de mémoire disposés dans la première direction étant associées une première et une deuxième ligne de bits et les zones de source/drain (14a, 14b, 14c, 14d) des transistors de mémoire de la rangée étant connectées de manière électro-conductrice alternativement à la première ligne de bits (BL1) et à la deuxième ligne de bits (BL2).

6. Réseau de cellules de mémoire selon la revendication 5, présentant par ailleurs un moyen destiné à introduire des charges sur la porte flottante (24) d'un transistor de mémoire (1) sélectionné du réseau de cellules de mémoire qui est conçu pour appliquer un potentiel avec une première polarité à laquelle un canal (40) est généré dans la zone de substrat à canal à la ligne de mot (WL) qui est connectée à la porte de commande (28) du transistor de mémoire sélectionné (1), et un potentiel avec une deuxième polarité opposée à la première polarité à l'une des zones de source/drain (14b) du transistor de mémoire sélectionné, pour amener des charges sur la porte flottante (24) du transistor de mémoire sélectionné (1).

7. Réseau de cellules de mémoire selon la revendication 6, dans lequel le moyen pour introduire des charges est par ailleurs conçu pour appliquer un potentiel de la première polarité à l'une des zones de source/drain des transistors de mémoire (2), à l'exception du transistor de mémoire sélectionné, dont les portes de commande sont reliées à la ligne de mot (WL) qui est reliée à la porte de commande du transistor de mémoire sélectionné (1).

8. Réseau de cellules de mémoire selon la revendication 7, présentant par ailleurs un moyen pour éliminer des charges de la porte flottante (24) d'un transistor de mémoire sélectionné (1) qui est conçu pour appliquer un potentiel de la deuxième polarité à la ligne de mot (WL) reliée à la porte de commande (28) du transistor de mémoire sélectionné (1) et un potentiel de la première polarité aux deux zones de source/drain (14a, 14b) du transistor de mémoire sélection (1), pour éliminer des charges de la porte flottante (24) du transistor de mémoire sélectionné (1).

9. Réseau de cellules de mémoire selon la revendication 8, dans lequel le moyen pour éliminer des charges est par ailleurs conçu pour appliquer un potentiel de la deuxième polarité sur les zones de source/drain des transistors de mémoire (2), à l'exception du transistor de mémoire sélectionné (1) dont les portes de commande sont reliées à la ligne de mot (WL) qui est reliée à la porte de commande (28) du transistor sélectionné (1).

10. Procédé de fabrication d'un réseau de cellules de mémoire selon l'une des revendications 1 à 9, aux étapes suivantes consistant à:
générer des fossés en forme de bande (30) remplis d'un matériau isolant dans un substrat semi-conducteur (16) disposé sur une couche isolante (12), les fossés isolants s'étendant jusqu'à la couche isolante (12);
générer des structures de porte (20) en forme de bande s'étendant sensiblement perpendiculaires aux fossés (30) remplis de matériau isolant qui constituent avec les fossés (30) une structure en forme de grille; et
doper les zones de substrat restant libres entre la structure en forme de grille, pour générer des zones de source/drain (14a, 14b, 14c, 14d) qui s'étendent jusqu'à la couche isolante (12),
des transistors de mémoire adjacents dans la direction des fossés (30) présentant une zone de source/drain commune (14a, 14b, 14c, 14d).

11. Procédé selon la revendication 10, présentant par ailleurs les étapes suivantes consistant à:
générer des lignes de mot sur les structures de porte; et
générer des lignes de bits (BL1, BL2, BL1', BL2'), à une rangée de zones de source/drain (14a, 14b, 14c, 14d) disposées dans la direction des fossés (30) remplis d'un matériau isolant étant chaque fois associées une première et une deuxième ligne de bits (BL1, BL2) et les zones de source/drain étant reliées alternativement à la première (BL1) et à la deuxième (BL2) ligne de bits.
